# EUROPÄISCHE PATENTSCHRIFT

(11) **EP 2 273 574 B1**
(45) Veröffentlichungstag und Bekanntmachung des Hinweises auf die Patenterteilung: **24.07.2019**
(21) Anmeldenummer: 10182208.8
(22) Anmeldetag: 16.03.2001
(51) Int. Cl.: H01L 33/00, H01L 33/32, H01L 33/40, H01L 33/42

(54) **Verfahren zum Herstellen eines Lumineszenzdiodenbauelements mit einem Lumineszenzdiodenchip auf der Basis von GaN**
Method for producing a light emitting diode with a light emitting diode chip on a GaN basis
Procédé de fabrication d'un composant à diodes luminescentes doté d'une puce à diode luminescente à base de GaN

(30) Priorität: 26.05.2000 DE 10026255; 26.04.2000 DE 10020464
(43) Veröffentlichungstag der Anmeldung: 12.01.2011
(62) Teilanmeldung aus: 01931364.2
(73) Patentinhaber: OSRAM Opto Semiconductors GmbH, 93055 Regensburg (DE)
(72) Erfinder: Bader, Stefan, 93080, Pentling - Matting (DE); Hahn, Berthold, 93155, Hemau (DE); Härle, Volker, 93164, Laaber (DE); Lugauer, Hans-Jürgen, 93161, Sinzing (DE); Mundbrod-Vangerow, Manfred, 89335, Oxenbronn (DE)
(74) Vertreter: Epping - Hermann - Fischer

(56) Entgegenhaltungen:
- EP-A1- 0 404 565
- EP-A2- 0 810 674
- DE-A1- 19 820 777
- DE-A1- 19 830 838
- DE-A1- 19 921 987
- JP-A- H0 864 910
- JP-A- H1 168 157
- JP-A- H10 150 220
- JP-A- H11 150 297
- JP-A- H11 191 641
- US-A- 5 585 649
- MENSZ P ET AL: "InxGa1-xN/AlyGa1-yN Violet Light Emitting Diodes with Reflective P-contacts", ELECTRONICS LETTERS, Bd. 33, Nr. 24, 20. November 1997 (1997-11-20), Seiten 2066-2068, XP000734311, ISSN: 0013-5194, DOI: 10.1049/EL:19971379

## Beschreibung

Die Erfindung bezieht sich auf Verfahren zum Herstellen eines Lumineszenzdiodenbauelements mit einem Lumineszenzdiodenchip auf der Basis von GaN.

Bei der Herstellung von Lumineszenzdiodenchips auf der Basis von GaN besteht das grundlegende Problem, dass die maximal erzielbare elektrische Leitfähigkeit von p-dotierten Schichten, insbesondere von p-dotierten GaN- oder AlGaN-Schichten, nicht ausreicht, um mit bei herkömmlichen Lumineszenzdiodenchips aus anderen Materialsystemen üblicherweise verwendeten Vorderseitenkontakten, die zur Erzielung möglichst hoher Strahlungsauskopplung nur einen Bruchteil der Vorderseite des Chips bedecken, eine Stromaufweitung über den gesamten lateralen Querschnitt des Chips zu erzielen.

Ein Aufwachsen der p-leitenden Schicht auf ein elektrisch leitendes Substrat, wodurch eine Stromeinprägung über den gesamten lateralen Querschnitt der p-leitenden Schicht möglich wäre, führt zu keinem wirtschaftlich vertretbarem Ergebnis. Die Gründe hierfür sind, dass die Herstellung von elektrisch leitenden gitterangepassten Substraten (z.B. GaN-Substraten) für das Aufwachsen von GaN-basierten Schichten mit hohem technischen Aufwand verbunden ist und dass das Aufwachsen von p-dotierten GaN-basierten Schichten auf für undotierte und n-dotierte GaN-Verbindungen geeignete nicht gitterangepassten Substrate zu keiner für eine Lumineszenzdiode hinreichenden Kristallqualität führt.

Bei einem bekannten Ansatz zur Bekämpfung des oben genannten Problems wird auf die vom Substrat abgewandte Seite der p-leitenden Schicht ganzflächig eine für die Strahlung durchlässige Kontaktschicht oder eine zusätzliche elektrisch gut leitfähige Schicht zur Stromaufweitung aufgebracht, die mit einem Bondkontakt versehen ist.

Der erstgenannte Vorschlag ist jedoch mit dem Nachteil verbunden, dass ein erheblicher Teil der Strahlung in der Kontaktschicht absorbiert wird. Beim zweitgenannten Vorschlag ist ein zusätzlicher Verfahrensschritt erforderlich, der den Fertigungsaufwand erhöht.

Die Druckschrift JP H11-191 641 A ist auf einen LED-Chip mit einer metallischen p-Kontaktstruktur gerichtet.

In dem Artikel Mensz P. et al., "InxGaN1-xN/AlyGa1-yN violet light emitting diodes with reflective p-contacts for high single sided light extraction", veröffentlicht in Electronics Letters, 20. November 1997, Vol. 23, No. 24, Seiten 2066 bis 2068, ist ein LED mit einer reflektierenden Kontaktstruktur offenbart.

Ferner findet sich eine LED auf der Basis von GaN mit einer metallischen Kontaktschicht an einer p-Seite in der Druckschrift DE 198 30 838 A1.

Aus der Druckschrift JP H11-150 297 A ist ein LED-Chip mit einer Kontaktstruktur aus verschiedenen Metallen bekannt.

Eine LED mit einer AuSn-Lotschicht und ein Herstellungsverfahren hierfür finden sich in der Druckschrift JP H11-068157 A.

Hinsichtlich einer AlGaAs-LED wird auf die Druckschrift EP 0 404 656 A1 hingewiesen.
Das japanische Abstract JP H10-150 220 A offenbart ein lichtemittierendes Halbleiterbauelement, bei dem eine n-GaN Halbleiterschicht, eine lichtemittierenden Schicht und eine p-GaN Halbleiterschicht aufeinanderfolgend auf ein n-GaN-Substrat aufgebracht sind. Auf der Oberfläche der p-GaN Halbleiterschicht ist eine diese im Wesentlichen vollständig bedeckende p-Elektrode angeordnet.

Aus der Druckschrift EP 0 810 674 A2 ist ein lichtemittierendes Halbleiterbauteil auf Basis eines GaAs-Substrats bekannt, wobei das GaAs-Substrat während eines Herstellungsverfahrens zumindest teilweise abgelöst wird.

In der Druckschrift DE 199 21 987 A1 ist eine LED mit einer p-Kontaktmetallisierung, umfassend mehrere Metalle, wiedergegeben.

Mehrere Metalle für die Elektroden von LEDs sind in der Druckschrift DE 198 20 777 A1 diskutiert, ebenso wie in der Druckschrift US 5 5585 649 A.

Die Aufgabe der Erfindung besteht darin, Verfahren zum Herstellen eines Lumineszenzdiodenbauelements mit einem Lumineszenzdiodenchip zur Verfügung zu stellen.

Diese Aufgabe wird mit den Verfahren mit den Merkmalen der Patentansprüche 1 oder 2 gelöst. Vorteilhafte Weiterbildungen sind Gegenstand der abhängigen Patentansprüche.

Bei einem Lumineszenzdiodenchip gemäß der Erfindung ist das Substrat elektrisch leitfähig. Auf das Substrat sind zunächst die n-leitenden Schichten der Epitaxieschichtenfolge aufgebracht. Auf dieser befinden sich die p-leitenden Schichten der Epitaxieschichtenfolge, gefolgt von einer lateral ganzflächig aufgebrachten reflektierenden, bondfähigen p-Kontaktschicht. Das Substrat ist an seiner von der Epitaxieschichtenfolge abgewandten Hauptfläche mit einer Kontaktmetallisierung versehen, die nur eine Teil dieser Hauptfläche bedeckt. Die Lichtauskopplung aus dem Chip erfolgt über den freien Bereich der Hauptfläche des Substrats und über die Chipflanken.

Das Substrat dient hier vorteilhafterweise als Fensterschicht, die die Auskopplung der im Chip erzeugten Strahlung verbessert. Zur Optimierung der Dicke des Substrats ist dieses vorteilhafterweise nach dem Aufwachsen der Epitaxieschichtenfolge beispielsweise mittels Schleifen und/oder Ätzen gedünnt.

Bei einem weiteren Lumineszenzdiodenchip gemäß der Erfindung weist der Chip ausschließlich Epitaxieschichten auf. Dazu ist ein Aufwachssubstrat nach dem epitaktischen Aufwachsen der Epitaxieschichtenfolge entfernt. Die p-leitende Epitaxieschicht ist auf ihrer von der n-leitenden Epitaxieschicht abgewandten Hauptfläche ganzflächig mit einer reflektierenden, bondfähigen p-Kontaktschicht versehen. Auf der von der p-leitenden Epitaxieschicht abgewandten Hauptfläche der n-leitenden Epitaxieschicht befindet sich eine n-Kontaktschicht, die nur einen Teil dieser Hauptfläche bedeckt. Die Lichtauskopplung aus dem Chip erfolgt über den freien Bereich der Hauptfläche der n-leitenden Epitaxieschicht und über die Chipflanken.

Das Aufwachssubstrat kann in diesem Fall sowohl elektrisch isolierend als auch strahlungsundurchlässig sein und demzufolge vorteilhafterweise allein hinsichtlich optimaler Aufwachsbedingungen ausgewählt werden.

Der besondere Vorteil eines derartigen sogenannten Dünnfilm-LED-Chips besteht in einer verringerten, idealerweise keiner Strahlungsabsorption im Chip und einer verbesserten Auskopplung der Strahlung aus dem Chip, insbesondere aufgrund der verminderten Anzahl von Grenzflächen mit Brechungsindexsprung.

Mit beiden erfindungsgemäßen Lumineszenzdiodenchips ist der besondere Vorteil verbunden, dass die Möglichkeit besteht, den Verlustwärme erzeugenden Bereich (insbesondere die p-dotierte Schicht und den pn-Übergang) des Chips sehr nahe an eine Wärmesenke zu bringen; die Epitaxieschichtenfolge ist praktisch unmittelbar an eine Wärmesenke thermisch ankoppelbar. Dadurch kann der Chip sehr effektiv gekühlt werden, wodurch die Stabilität der ausgesandten Strahlung erhöht ist. Ebenso ist auch der Wirkungsgrad des Chips erhöht.

Bei beiden erfindungsgemäßen Lumineszenzdiodenchips ist aufgrund der ganzflächigen Kontaktierung vorteilhafterweise die Flussspannung reduziert.

Bei den erfindungsgemäßen Lumineszenzdiodenchips besteht die p-Kontaktschicht aus einer auf die p-Seite aufgebrachten transparenten ersten Schicht und einer auf diese aufgebrachte spiegelnde zweite Schicht. Dadurch kann die Kontaktschicht auf einfache Weise sowohl hinsichtlich ihrer elektrischen Eigenschaften als auch ihrer Reflexionseigenschaften optimiert werden.

Materialien für die erste und zweite Schicht sind Pt oder Pd bzw. Ag oder Al.

In einer weiteren bevorzugten Ausführungsform ist die gesamte freie Oberfläche des durch die Schichtenfolge gebildeten Halbleiterkörpers oder ein Teilbereich davon aufgeraut. Durch diese Aufrauung wird die Totalreflektion an der Auskoppelfläche gestört und dadurch mit Vorteil der optische Auskopplungsgrad weiter erhöht.

Bei einem Verfahren zum Herstellen eines Lumineszenzdiodenbauelements mit einem Lumineszenzdiodenchip gemäß der Erfindung wird der Chip mit der p-Seite auf eine Chipmontagefläche eines elektrischen Anschlussteils, insbesondere eines elektrischen Leiterrahmens, montiert.

In einer besonders bevorzugten Weiterbildung wird das Herstellungsverfahren fortgeführt durch eine Aufrauung des durch die Schichtenfolge gebildeten Halbleiterkörpers, wobei die gesamte freie Oberfläche des Halbleiterkörpers oder Teilbereiche hiervon aufgeraut werden. Eine bezüglich der Erhöhung der Lichtausbeute besonders effektive Aufrauung wird durch Anätzen des Halbleiterkörpers oder mittels eines Sandstrahlverfahrens hergestellt.

Weitere vorteilhafte Ausgestaltungen der Erfindung ergeben sich aus den im Folgenden in Verbindung mit den Figuren 1a bis 5 beschriebenen Ausführungsbeispielen. Es zeigen:
Figur 1a, eine schematische Darstellung eines Schnittes durch ein erstes Ausführungsbeispiel;
Figur 1b, eine schematische Darstellung eines bevorzugten p-Kontaktschicht ;
Figur 2, eine schematische Darstellung eines Schnittes durch ein zweites Ausführungsbeispiel;
Figuren 3a bis 3c, eine schematische Darstellung eines Verfahrensablaufes zur Herstellung des Ausführunsbeispieles gemäß Figur 1a;
Figuren 4a bis 4e, eine schematische Darstellung eines Verfahrensablaufes zur Herstellung des Ausführunsbeispieles gemäß Figur 2;
Figur 5, eine schematische Schnittansicht eines weiteren Ausführungsbeispiels eines erfindungsgemäßen Lumineszenzdiodenchips.

In den Figuren der verschiedenen Ausführungsbeispiele sind gleiche oder gleichwirkende Bestandteile jeweils mit denselben oder ähnlichen Bezugszeichen versehen.

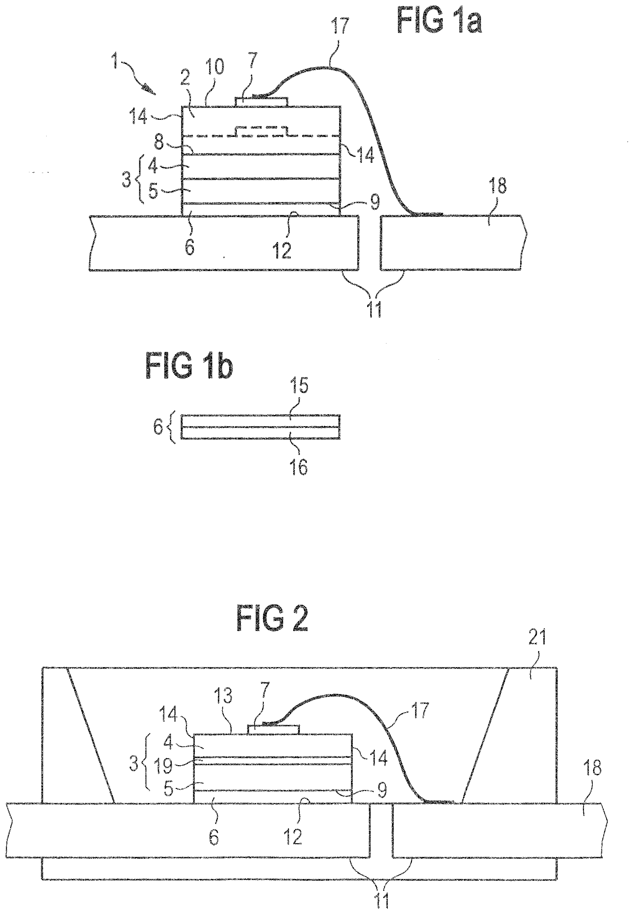

Bei dem Lumineszenzdiodenchip 1 von Figur 1a ist auf einem SiC-Substrat 2 eine strahlungsemittierende Epitaxieschichtenfolge 3 aufgebracht. Diese weist eine n-leitend dotierte GaN- oder AlGaN-Epitaxieschicht 4 und eine p-leitend dotierte GaN- oder AlGaN-Epitaxieschicht 5 auf. Ebenso kann beispielsweise eine auf GaN basierende Epitaxieschichtenfolge 3 mit einer Doppelheterostruktur, einer Einfach-Quantenwell(SQW)-Struktur oder einer Multi-Quantenwell(MQW)-Struktur mit einer bzw. mehreren undotierten Schicht(en) 19, beispielsweise aus InGaN oder InGaAlN, vorgeshen sein.

Das SiC-Substrat 2 ist elektrisch leitfähig und für die von der Epitaxieschichtenfolge 3 ausgesandte Strahlung durchlässig.

Auf ihrer vom SiC-Substrat 2 abgewandten p-Seite 9 ist auf die Epitaxieschichtenfolge 3 ganzflächig eine reflektierende, bondfähige p-Kontaktschicht 6 aufgebracht.

Die p-Kontaktschicht 6, wie in Figur 1b schematisch dargestellt, ist aus einer strahlungsdurchlässigen ersten Schicht 15 und einer spiegelnden zweiten Schicht 16 zusammengesetzt. Die erste Schicht 15 besteht aus Pt oder Pd und die zweite Schicht 16 aus Ag oder Al.

An seiner von der Epitaxieschichtenfolge 3 abgewandten Hauptfläche 10 ist das SiC-Substrat 2 mit einer Kontaktmetallisierung 7 versehen, die nur einen Teil dieser Hauptfläche 10 bedeckt und als Bondpad zum Drahtbonden ausgebildet ist.

Die Kontaktmetallisierung 7 besteht beispielsweise aus einer auf das SiC-Substrat 2 aufgebrachten Ni-Schicht, gefolgt von einer Au-Schicht.

Der Chip 1 ist mittels Die-Bonden mit seiner p-Seite, das heißt mit der p-Kontaktschicht 6 auf eine Chipmontagefläche 12 eines elektrischen Anschlußrahmens 11 (Leadframe) montiert. Die n-Kontaktmetallisierung 7 ist über einen Bonddraht 17 mit einem Anschlußteil 18 des Anschlußrahmens 11 verbunden.

Die Lichtauskopplung aus dem Chip 1 erfolgt über den freien Bereich der Hauptfläche 10 des SiC-Substrats 2 und über die Chipflanken 14.

Optional weist der Chip 1 ein nach dem Aufwachsen der Epitaxieschichtenfolge 3 gedünntes SiC-Substrat 2 auf (dies ist in Figur la mit Hilfe der gestrichelten Linien angedeutet).

Das in Figur 2 dargestellte Ausführungsbeispiel unterscheidet sich von dem der Figur la zum einen dadurch, dass der Chip 1 ausschließlich Epitaxieschichten der Epitaxieschichtenfolge 3 und keine Substratschicht aufweist. Letztere wurde nach dem Aufwachsen der Epitaxieschichten beispielsweise mittels Ätzen und/oder Schleifen entfernt. Hinsichtlich der Vorteile eines derartigen sogenannten Dünnfilm-LED-Chips wird auf den allgemeinen Teil der Beschreibung verwiesen. Zum anderen weist die Epitaxieschichtenfolge 3 eine Doppelheterostruktur, eine Einfach-Quantenwell(SQW)-Struktur oder eine Multi-Quantenwell(MQW)-Struktur mit einer bzw. mehreren undotierten Schicht(en) 19, beispielsweise aus InGaN oder InGaAlN auf. Beispielhaft ist hier auch ein LED-Gehäuse 21 schematisch dargestellt.

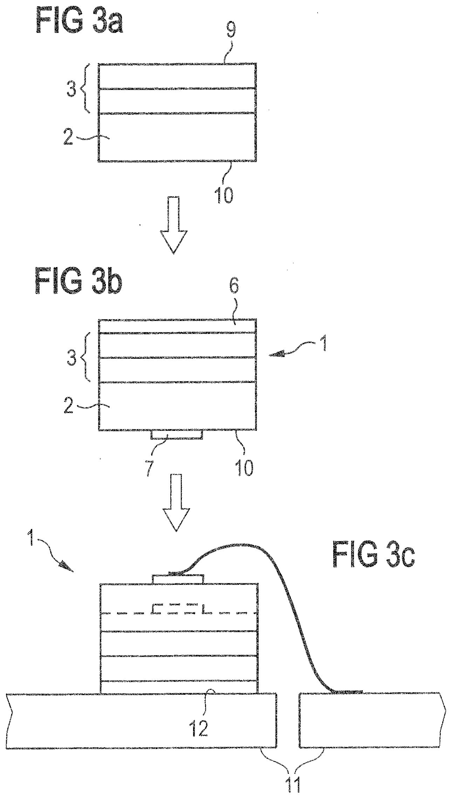

Bei dem in den Figuren 3a bis 3c schematisch dargestellten Verfahrensablauf zum Herstellen eines Lumineszenzdiodenbauelements mit einem Lumineszenzdiodenchip 1 gemäß Figur 1a wird zunächst die strahlungsemittierende Epitaxieschichtenfolge 3 auf das SiC-Substrat 2 aufgewachsen (Figur 3a). Nachfolgend wird auf die p-Seite 9 der Epitaxieschichtenfolge 3 ganzflächig die bondfähige p-Kontaktschicht 6 und auf einen Teilbereich der von der Epitaxieschichtenfolge 3 abgewandten Hauptfläche 10 des Substrats 2 die n-Kontaktschicht 7 aufgebracht (Figur 3b). Diese Prozess-Schritte finden alle im sogenannten Waferverbund statt, wodurch eine Vielzahl von Chips gleichzeitig nebeneinander herstellbar sind.

Nach den oben beschriebenen Prozess-Schritten wird der Waferverbund in einzelne Chips 1 zertrennt. Die einzelnen Chips werden anschließend mittels Löten jeweils mit der bondfähigen p-Kontaktschicht 6 auf eine Chipmontagefläche 12 eines elektrischen Leiterrahmens 11 montiert (Figur 3c).

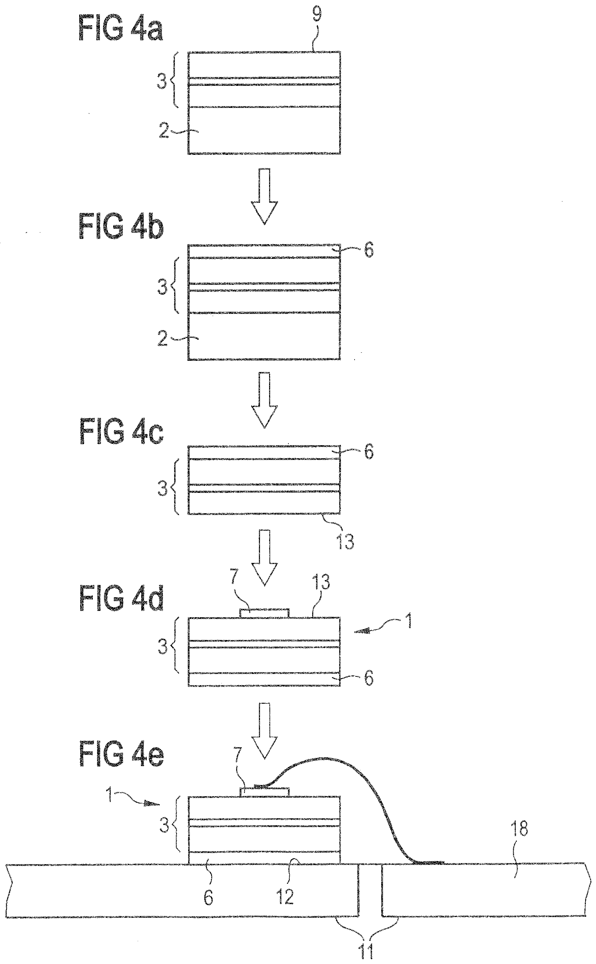

Das in den Figuren 4a bis 4e schematisch dargestellte Verfahren zum Herstellen eines Lumineszenzdiodenbauelements mit einem Lumineszenzdiodenchip 1 gemäß Figur 2 unterscheidet sich von dem der Figuren 3a bis 3c im Wesentlichen dadurch, dass nach dem Aufwachsen der Epitaxieschichtenfolge 3 und vor oder nach dem Aufbringen der p-Kontaktschicht 6 das Substrat 2 entfernt wird (Figur 4c). Das Substrat 2 kann in diesem Fall sowohl elektrisch isolierend als auch strahlungsundurchlässig sein und demzufolge vorteilhafterweise allein hinsichtlich optimaler Aufwachsbedingungen ausgelegt werden.

Nach dem Entfernen des Substrats 2 wird auf die n-Seite 13 der Epitaxieschichtenfolge 3 die n-Kontaktmetallisierung 7 aufgebracht (Figur 4d), bevor dann analog die oben in Verbindung mit der Figur 3c bereits beschriebenen Montageschritte erfolgen (Figur 4e).

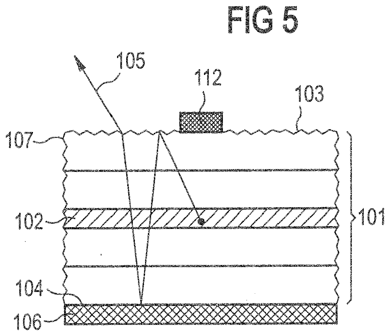

Das in Figur 5 dargestellte Ausführungsbeispiel weist eine Mehrzahl von stapelförmig angeordneten, unterschiedlichen Halbleiterschichten 101 auf, die aus GaN oder einer darauf basierenden ternären oder quaternären Verbindung bestehen. Im Betrieb bildet sich innerhalb dieser Schichten eine aktive Zone 102 aus, in der die Strahlung 105 generiert wird.

Der Schichtstapel wird von einer ersten Hauptfläche 103 und einer zweiten Hauptfläche 104 begrenzt. Im Wesentlichen wird die erzeugte Strahlung 105 durch die erste Hauptfläche 103 in die angrenzende Umgebung ausgekoppelt.

Auf der zweiten Hauptfläche 104 ist eine reflektierende, bondfähige p-Kontaktschicht 106 aufgebracht, wie weiter oben beschrieben. Kontaktiert wird der Halbleiterkörper auf der Auskopplungsseite über die Kontaktfläche 112 sowie reflektorseitig über die p-Kontaktschicht 106. Die reflektorseitige Kontaktierung kann beispielsweise dadurch erfolgen, dass der Halbleiterkörper reflektorseitig auf einen Metallkörper aufgesetzt ist, der sowohl als Träger wie auch der Stromzuführung dient.

Der Reflektor 106 bewirkt, dass ein Teil der Strahlung 105, die bei der Auskopplung an der ersten Hauptfläche 103 in den Halbleiterkörper zurückreflektiert wird, wiederum in Richtung der ersten Hauptfläche 103 reflektiert wird, sodass insgesamt die durch die erste Hauptfläche 103 ausgekoppelte Strahlungsmenge erhöht wird. Diese Erhöhung wird dadurch ermöglicht, dass das Bauelement als Dünnschichtbauelement ohne stahlungsabsorbierendes Substrat ausgeführt ist und der Reflektor 106 direkt auf dem GaN-Halbleiterkörper aufgebracht ist.

Die Oberfläche des Halbleiterkörpers weist dabei eine Aufrauung 107 auf. Diese Aufrauung 107 bewirkt eine Streuung der Strahlung 105 an der ersten Hauptfläche 103, sodass die Totalreflexion an der ersten Hauptfläche 103 gestört wird. Weitergehend verhindert diese Streuung, dass die erzeugte Strahlung durch fortlaufende, gleichartige Reflexionen zwischen den beiden Hauptflächen 103 und 104 bzw. dem Reflektor 106 nach Art eines Lichtleiters geführt wird, ohne den Halbleiterkörper zu verlassen. Somit wird durch die Aufrauhung 107 die Lichtausbeute weiter erhöht.
- Figur 2: eine schematische Darstellung eines Schnittes durch ein zweites Ausführungsbeispiel;
- Figuren 3a bis 3c: eine schematische Darstellung eines Verfahrensablaufes zur Herstellung des Ausführungsbeispieles gemäß Figur 1a;
- Figuren 4a bis 4e: eine schematische Darstellung eines Verfahrensablaufes zur Herstellung des Ausführungsbeispieles gemäß Figur 2;
- Figur 5: eine schematische Schnittansicht eines weiteren Ausführungsbeispiels eines erfindungsgemäßen Lumineszenzdiodenchips.

In den Figuren der verschiedenen Ausführungsbeispiele sind gleiche oder gleich wirkende Bestandteile jeweils mit denselben oder ähnlichen Bezugszeichen versehen.

Bei dem Lumineszenzdiodenchip 1 von Figur 1a ist auf einem SiC-Substrat 2 eine strahlungsemittierende Epitaxieschichtenfolge 3 aufgebracht. Diese weist beispielsweise eine n-leitend dotierte GaN- oder AlGaN-Epitaxieschicht 4 und eine p-leitend dotierte GaN- oder AlGaN-Epitaxieschicht 5 auf. Ebenso kann beispielsweise eine auf GaN basierende Epitaxieschichtenfolge 3 mit einer Doppelheterostruktur, einer Einfach-Quantenwell(SQW)-Struktur oder einer Multi-Quantenwell(MQW)-Struktur mit einer beziehungsweise mehreren undotierten Schicht(en) 19, beispielsweise aus InGaN oder InGaAlN, vorgesehen sein.

Das SiC-Substrat 2 ist elektrisch leitfähig und für die von der Epitaxieschichtenfolge 3 ausgesandte Strahlung durchlässig.

Auf ihrer vom SiC-Substrat 2 abgewandten p-Seite 9 ist auf die Epitaxieschichtenfolge 3 im Wesentlichen ganzflächig eine reflektierende, bondfähige p-Kontaktschicht 6 aufgebracht. Diese besteht beispielsweise im Wesentlichen aus Ag, aus einer PtAg- und/oder einer PdAg-Legierung.

Die p-Kontaktschicht 6 kann aber auch, wie in Figur 1b schematisch dargestellt, aus einer strahlungsdurchlässigen ersten Schicht 15 und einer spiegelnden zweiten Schicht 16 zusammengesetzt sein. Die erste Schicht 15 besteht beispielsweise im Wesentlichen aus Pt und/oder Pd und die zweite Schicht 16 beispielsweise im Wesentlichen aus Ag, Au und/oder Al oder einer dielektrischen Spiegelschicht.

An seiner von der Epitaxieschichtenfolge 3 abgewandten Hauptfläche 10 ist das SiC-Substrat 2 mit einer Kontaktmetallisierung 7 versehen, die nur einen Teil dieser Hauptfläche 10 bedeckt und als Bondpad zum Drahtbonden ausgebildet ist. Die Kontaktmetallisierung 7 besteht beispielsweise aus einer auf das SiC-Substrat 2 aufgebrachten Ni-Schicht, gefolgt von einer Au-Schicht.

Der Chip 1 ist mittels Die-Bonden mit seiner p-Seite, das heißt mit der p-Kontaktschicht 6 auf eine Chipmontagefläche 12 eines elektrischen Anschlußrahmens 11 (Leadframe) montiert. Die n-Kontaktmetallisierung 7 ist über einen Bonddraht 17 mit einem Anschlußteil 18 des Anschlußrahmens 11 verbunden.

Die Lichtauskopplung aus dem Chip 1 erfolgt über den freien Bereich der Hauptfläche 10 des SiC-Substrats 2 und über die Chipflanken 14.

Optional weist der Chip 1 ein nach dem Aufwachsen der Epitaxieschichtenfolge 3 gedünntes SiC-Substrat 2 auf (dies ist in Figur 1a mit Hilfe der gestrichelten Linien angedeutet).

Das in Figur 2 dargestellte Ausführungsbeispiel unterscheidet sich von dem der Figur 1a zum einen dadurch, dass der Chip 1 ausschließlich Epitaxieschichten der Epitaxieschichtenfolge 3 und keine Substratschicht aufweist. Letztere wurde nach dem Aufwachsen der Epitaxieschichten beispielsweise mittels Ätzen und/oder Schleifen entfernt. Hinsichtlich der Vorteile eines derartigen sogenannten Dünnfilm-LED-Chips wird auf den allgemeinen Teil der Beschreibung verwiesen. Zum anderen weist die Epitaxieschichtenfolge 3 eine Doppelheterostruktur, eine Einfach-Quantenwell(SQW)-Struktur oder eine Multi-Quantenwell(MQW)-Struktur mit einer beziehungsweise mehreren undotierten Schicht(en) 19, beispielsweise aus InGaN oder InGaAlN auf. Beispielhaft ist hier auch ein LED-Gehäuse 21 schematisch dargestellt.

Bei dem in den Figuren 3a bis 3c schematisch dargestellten Verfahrensablauf zum Herstellen eines Lumineszenzdiodenbauelements mit einem Lumineszenzdiodenchip 1 gemäß Figur 1a wird zunächst die strahlungsemittierende Epitaxieschichtenfolge 3 auf das SiC-Substrat 2 aufgewachsen (Figur 3a). Nachfolgend wird auf die p-Seite 9 der Epitaxieschichtenfolge 3 ganzflächig die bondfähige p-Kontaktschicht 6 und auf einen Teilbereich der von der Epitaxieschichtenfolge 3 abgewandten Hauptfläche 10 des Substrats 2 die n-Kontaktschicht 7 aufgebracht (Figur 3b). Diese Prozess-Schritte finden alle im so genannten Waferverbund statt, wodurch eine Vielzahl von Chips gleichzeitig nebeneinander herstellbar sind.

Nach den oben beschriebenen Prozess-Schritten wird der Waferverbund in einzelne Chips 1 zertrennt. Die einzelnen Chips werden anschließend mittels Löten jeweils mit der bondfähigen p-Kontaktschicht 6 auf eine Chipmontagefläche 12 eines elektrischen Leiterrahmens 11 montiert (Figur 3c).

Das in den Figuren 4a bis 4e schematisch dargestellte Verfahren zum Herstellen eines Lumineszenzdiodenbauelements mit einem Lumineszenzdiodenchip 1 gemäß Figur 2 unterscheidet sich von dem der Figuren 3a bis 3c im Wesentlichen dadurch, dass nach dem Aufwachsen der Epitaxieschichtenfolge 3 und vor oder nach dem Aufbringen der p-Kontaktschicht 6 das Substrat 2 entfernt wird (Figur 4c). Das Substrat 2 kann in diesem Fall sowohl elektrisch isolierend als auch strahlungsundurchlässig sein und demzufolge vorteilhafterweise allein hinsichtlich optimaler Aufwachsbedingungen ausgelegt werden.

Nach dem Entfernen des Substrats 2 wird auf die n-Seite 13 der Epitaxieschichtenfolge 3 die n-Kontaktmetallisierung 7 aufgebracht (Figur 4d), bevor dann analog den oben in Verbindung mit der Figur 3c bereits beschriebenen Montageschritte erfolgen (Figur 4e).

Das in Figur 5 dargestellte Ausführungsbeispiel weist eine Mehrzahl von stapelförmig angeordneten, unterschiedlichen Halbleiterschichten 101 auf, die aus GaN oder einer darauf basierenden ternären oder quaternären Verbindung bestehen. Im Betrieb bildet sich innerhalb dieser Schichten eine aktive Zone 102 aus, in der die Strahlung 105 generiert wird.

Der Schichtstapel wird von einer ersten Hauptfläche 103 und einer zweiten Hauptfläche 104 begrenzt. Im Wesentlichen wird die erzeugte Strahlung 105 durch die erste Hauptfläche 103 in die angrenzende Umgebung ausgekoppelt.

Auf der zweiten Hauptfläche 104 ist eine reflektierende, bondfähige p-Kontaktschicht 106 aufgebracht, wie weiter oben beschrieben. Kontaktiert wird der Halbleiterkörper auf der Auskopplungsseite über die Kontaktfläche 112 sowie reflektorseitig über die p-Kontaktschicht 106. Die reflektorseitige Kontaktierung kann beispielsweise dadurch erfolgen, dass der Halbleiterkörper reflektorseitig auf einen Metallkörper aufgesetzt ist, der sowohl als Träger wie auch der Stromzuführung dient.

Der Reflektor 106 bewirkt, dass ein Teil der Strahlung 105, die bei der Auskopplung an der ersten Hauptfläche 103 in den Halbleiterkörper zurückreflektiert wird, wiederum in Richtung der ersten Hauptfläche 103 reflektiert wird, so dass insgesamt die durch die erste Hauptfläche 103 ausgekoppelte Strahlungsmenge erhöht wird. Diese Erhöhung wird dadurch ermöglicht, dass das Bauelement als Dünnschichtbauelement ohne strahlungsabsorbierendes Substrat ausgeführt ist und der Reflektor 106 direkt auf dem GaN-Halbleiterkörper aufgebracht ist.

Die Oberfläche des Halbleiterkörpers weist dabei eine Aufrauung 107 auf. Diese Aufrauung 107 bewirkt eine Streuung der Strahlung 105 an der ersten Hauptfläche 103, so dass die Totalreflexion an der ersten Hauptfläche 103 gestört wird. Weitergehend verhindert diese Streuung, dass die erzeugte Strahlung durch fortlaufende, gleichartige Reflexionen zwischen den beiden Hauptflächen 103 und 104 beziehungsweise dem Reflektor 106 nach Art eines Lichtleiters geführt wird, ohne den Halbleiterkörper zu verlassen. Somit wird durch die Aufrauung 107 die Lichtausbeute weiter erhöht.

Die Erläuterung der Erfindung anhand der obigen Ausführungsbeispiele ist selbstverständlich nicht als Einschränkung auf diese zu verstehen. Die Erfindung ist vielmehr insbesondere bei allen Lumineszenzdiodenchips nutzbar, bei denen die von einem Aufwachssubstrat entfernt liegende Epitaxieschicht eine unzureichende elektrische Leitfähigkeit aufweist.

## Patentansprüche

1. Verfahren zum Herstellen eines Lumineszenzdiodenbauelements mit einem Lumineszenzdiodenchip (1) auf der Basis von GaN,
mit den Verfahrensschritten:
a) Epitaktisches Aufwachsen einer strahlungsemittierenden Epitaxieschichtenfolge (3) auf ein elektrisch leitfähiges Substrat (2), das für die von der Epitaxieschichtenfolge (3) ausgesandte Strahlung durchlässig ist, derart, dass eine n-Seite (8) der Epitaxieschichtenfolge (3) dem Substrat (2) zugewandt und eine p-Seite (9) der Epitaxieschichtenfolge (3) vom Substrat (2) abgewandt ist,
b) ganzflächiges Aufbringen einer bondfähigen p-Kontaktschicht (6) auf die p-Seite (9) der Epitaxieschichtenfolge (3) durch Aufbringen einer transparenten ersten Schicht (15) direkt auf die p-Seite (9) und Aufbringen einer spiegelnden zweiten Schicht (16) direkt auf der ersten Schicht (15), sodass die p-Kontaktschicht (6) aus der ersten Schicht (15) und der zweiten Schicht (16) besteht und die erste Schicht (15) Pt oder Pd aufweist und die zweite Schicht (16) Ag oder A1 aufweist,
c) Aufbringen einer n-Kontaktschicht (7) auf einen Teilbereich einer von der Epitaxieschichtenfolge (3) abgewandten Hauptfläche (10) des Substrats (2),
d) Aufbringen des Chips (1) auf eine Chipmontagefläche (12) eines LED-Gehäuses, einer Leiterbahn in einem LED-Gehäuse oder eines elektrischen Anschlussrahmens (11), mit der bondfähigen p-Kontaktschicht (6) zur Chipmontagefläche hin.

2. Verfahren zum Herstellen eines Lumineszenzdiodenbauelements mit einem Lumineszenzdiodenchip (1) auf der Basis von GaN,
mit den Verfahrensschritten:
a) Epitaktisches Aufwachsen einer strahlungsemittierenden Epitaxieschichtenfolge (3) auf ein Substrat (2), derart, dass eine n-Seite (8) der Epitaxieschichtenfolge (3) dem Substrat (2) zugewandt und eine p-Seite (9) der Epitaxieschichtenfolge (3) vom Substrat (2) abgewandt ist,
b) ganzflächiges Aufbringen einer bondfähigen p-Kontaktschicht (6) auf die p-Seite (9) der Epitaxieschichtenfolge (3) durch Aufbringen einer transparenten ersten Schicht (15) direkt auf die p-Seite (9) und Aufbringen einer spiegelnden zweiten Schicht (16) direkt auf der ersten Schicht (15), sodass die p-Kontaktschicht (6) aus der ersten Schicht (15) und der zweiten Schicht (16) besteht und die erste Schicht (15) Pt oder Pd aufweist und die zweite Schicht (16) Ag oder Al aufweist,
c) Entfernen des Substrats (2) von der Epitaxieschichtenfolge (3)
d) Aufbringen einer n-Kontaktschicht (7) auf einen Teilbereich der in Schritt c) freigelegten Hauptfläche (13) der Epitaxieschichtenfolge (3),
e) Aufbringen des Chips (1) auf eine Chipmontagefläche (12) eines LED-Gehäuses, einer Leiterbahn in einem LED-Gehäuse oder eines elektrischen Anschlussrahmens (11), mit der bondfähigen p-Kontaktschicht (6) zur Chipmontagefläche hin.

3. Verfahren nach Anspruch 1,
wobei vor dem Aufbringen der n-Kontaktschicht (7) das Substrat (2) gedünnt wird.

4. Verfahren nach Anspruch 1,
wobei das Substrat (2) ein Siliziumcarbid-Substrat ist.

5. Verfahren nach einem der vorherigen Ansprüche,
wobei die Schichtfolge (3) ganz oder in einem Teilbereich aufgeraut wird.

6. Verfahren nach Anspruch 5,
wobei die Schichtfolge (3) durch Ätzen aufgeraut wird.

7. Verfahren nach Anspruch 5, wobei die Schichtfolge (3) durch ein Sandstrahlverfahren aufgeraut wird.

## Claims

1. A method for producing a luminescence diode component having a luminescence diode chip (1) on the basis of GaN, comprising the steps:
A) epitaxially growing a radiation-emitting epitaxial layer sequence (3) onto an electrically conductive substrate (2) which is transmissive to the radiation emitted by the epitaxial layer sequence (3) in such a way that an n-side (8) of the epitaxial layer sequence (3) faces the substrate (2) and a p-side (9) of the epitaxial layer sequence (3) faces away from the substrate (2),
B) whole-area application of a bondable p-contact layer (6) to the p-side (9) of the epitaxial layer sequence (3) by applying a transparent first layer (15) directly onto the p-side (9) and by applying a reflective second layer (16) directly on the first layer, so that the p-contact layer (6) is composed of the first layer (15) and of the second layer (16) and the first layer (15) has Pt or Pd and the second layer (16) has Ag or Al,
C) applying an n-contact layer (7) to a partial region of a main side of the substrate (2), the main side facing away from the epitaxial layer sequence (3),
D) applying the chip (1) to a chip mounting surface (12) of an LED housing, of a conductor track in an LED housing or of an electrical connection frame (11), with the bondable p-contact layer (6) towards the chip mounting surface.

2. A method for producing a luminescence diode component having a luminescence diode chip (1) on the basis of GaN, comprising the steps:
A) epitaxially growing a radiation-emitting epitaxial layer sequence (3) onto a substrate (2) in such a way that an n-side (8) of the epitaxial layer sequence (3) faces the substrate (2) and a p-side (9) of the epitaxial layer sequence (3) faces away from the substrate (2),
B) whole-area application of a bondable p-contact layer (6) to the p-side (9) of the epitaxial layer sequence (3) by applying a transparent first layer (15) directly onto the p-side (9) and by applying a reflective second layer (16) directly on the first layer (15), so that the p-contact layer (6) is composed the first layer (15) and of the second layer (16) and the first layer (15) has Pt or Pd and the second layer (16) has Ag or Al,
c) removal of the substrate (2) from the epitaxial layer sequence (3),
D) applying an n-contact layer (7) to a partial region of the main side (13) of the epitaxial layer sequence (3) exposed in step C),
E) applying the chip (1) to a chip mounting surface (12) of an LED housing, of a conductor track in an LED housing or of an electrical connection frame (11), with the bondable p-contact layer (6) towards the chip mounting surface.

3. The method according to claim 1,
wherein the substrate (2) is thinned prior to the application of the n-contact layer (7).

4. The method according to claim 1,
wherein the substrate (2) is a silicon carbide substrate.

5. The method according to one of the preceding claims,
wherein the layer sequence (3) is roughened entirely or in a partial region.

6. The method according to claim 5,
wherein the layer sequence (3) is roughened by etching.

7. The method according to claim 5,
wherein the layer sequence (3) is roughened by a sandblasting process.

## Revendications

1. Procédé de fabrication d'un composant de diode électroluminescente comportant une puce à diode électroluminescente (1) à base de GaN,
comprenant les étapes de procédé suivantes :
a) croissance épitaxiale d'une séquence de couches épitaxiales (3) émettant des rayonnements sur un substrat (2) électriquement conducteur transparent pour le rayonnement émis par la séquence de couches épitaxiales (3), de telle sorte qu'une face n (8) de la séquence de couches épitaxiales (3) soit en regard du substrat (2) et qu'une face p (9) de la séquence de couches épitaxiales (3) soit détournée du substrat (2),
b) application sur toute la surface d'une couche de contact p liable (6) sur la face p (9) de la séquence de couches épitaxiales (3) par dépôt d'une première couche transparente (15) directement sur la face p (9) et par dépôt d'une seconde couche réfléchissante (16) spéculaire directement sur la première couche (15), de manière que la couche de contact p (6) se compose de la première couche (15) et de la seconde couche (16), la première couche (15) comprenant du potassium ou du palladium, la seconde couche (16) comprenant de l'argent ou de l'aluminium,
c) dépôt d'une couche de contact n (7) sur une partie d'une face principale (10) du substrat (2) détournée de la séquence de couches épitaxiales (3),
d) dépôt de la puce (1) sur une surface de montage de puce (12) d'un boîtier de LED, d'une piste conductrice dans un boîtier de LED ou d'un cadre de connexion électrique (11), la couche de contact p (6) liable étant orientée vers la surface de montage de puce.

2. Procédé de fabrication d'un composant de diode électroluminescente comportant une puce à diode électroluminescente (1) à base de GaN,
comprenant les étapes de procédé suivantes :
a) Croissance épitaxiale d'une séquence de couches épitaxiales (3) émettant des rayonnements sur un substrat (2) de telle sorte qu'une face n (8) de la séquence de couches épitaxiales (3) soit en regard du substrat (2) et qu'une face p (9) de la séquence de couches épitaxiales (3) soit détournée du substrat (2),
b) dépôt sur toute la surface d'une couche de contact p liable (6) sur la face p (9) de la séquence de couches épitaxiales (3) par dépôt d'une première couche transparente (15) directement sur la face p (9) et par dépôt d'une seconde couche réfléchissante (16) spéculaire sur la première couche (15), de manière que la couche de contact p (6) se compose de la première couche (15) et de la seconde couche (16), la première couche (15) comprenant du potassium ou du palladium, la seconde couche (16) comprenant de l'argent ou de l'aluminium,
c) prélèvement du substrat (2) depuis la séquence de couches épitaxiales (3),
d) dépôt d'une couche de contact n (7) sur une partie de la face principale (13) de la séquence de couches épitaxiales (3) ayant été dégagée en étape c),
e) mise en place de la puce (1) sur une surface de montage de puce (12) d'un boîtier de LED, d'une piste conductrice dans un boîtier de LED ou d'un cadre de connexion électrique (11), la couche de contact p (6) liable étant orientée vers la surface de montage de puce.

3. Procédé selon la revendication 1, dans lequel le substrat (2) est aminci avant le dépôt de la couche de contact n (7).

4. Procédé selon la revendication 1, dans lequel le substrat (2) est un substrat de carbure de silicium.

5. Procédé selon l'une des revendications précédentes, dans lequel
la séquence de couches (3, 101) est rendue rugueuse entièrement ou partiellement.

6. Procédé selon la revendication 5, dans lequel la séquence de couches (3, 101) est rendue rugueuse par gravure.

7. Procédé selon la revendication 5, dans lequel la séquence de couches (3, 101) est rendue rugueuse par sablage.
